(19) Europäisches Patentamt
European Patent Office
Office européen des brevets

(11) **EP 2 821 803 A1**

(12) **EUROPEAN PATENT APPLICATION**

(43) Date of publication:
**07.01.2015  Bulletin 2015/02**

(51) Int Cl.:
*G01R 31/36* *(2006.01)*

(21) Application number: **13174720.6**

(22) Date of filing: **02.07.2013**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **Delphi Technologies, Inc.**
**Troy, MI 48007 (US)**

(72) Inventor: **Hirsch, Krystian**
**42389 Wuppertal (DE)**

(74) Representative: **Manitz, Finsterwald & Partner GbR**
**Martin-Greif-Strasse 1**
**80336 München (DE)**

(54) **Battery deterioration determining system**

(57)     The invention relates to a system (10) and method for determining the deterioration of a battery (14), particularly in an automotive system. The system comprises a battery sensor (12) configured to measure voltage values depending on respective voltages of the battery and to measure current values depending on respective currents of the battery; and an evaluation device (20) connected to the battery sensor for receiving the voltage and current values from the battery sensor, the evaluation device being adapted to generate a deterioration signal (26) in response to the received voltage and current values. The battery sensor is configured to synchronously measure a sequence of voltage values (22) and a sequence of current values (24), and the evaluation device is adapted to fit a model to said sequences, to derive a goodness of fit (34) from the fitting, and to generate the deterioration signal based on the goodness of fit.

Fig. 4

EP 2 821 803 A1

## Description

The invention relates to a system and a method for determining the deterioration of a battery, particularly in an automotive system.

In a modern vehicle, batteries, which typically are lead-acid type batteries, are playing an important role as storage of energy. Especially SLI (starting, lighting, ignition) batteries are essential to a vehicle's operation. Automotive batteries, however, can serve a wide variety of further purposes such as buffering during peak demands or providing energy to "living" systems of commercial vehicles, for example. Increasingly, automotive batteries also serve as storage for potentially to-be-recuperated energy such as braking energy.

In order to reliably use a battery for those purposes, it is crucial to determine the internal state of the battery, i.e. to reliably estimate the battery's ability to provide energy and power, and particularly in what quantity energy and power can be provided.

Several parameters for indicating the performance of a battery are known, some of them being defined by international standards. Such parameters are, for example, Cold Cranking Amperes (CCA) and the I/20 nominal capacity, the initial values of which are generally available from the battery specification. The CCA value indicates the battery's initial ability to deliver high current for short time events like engine cranks in low temperature. The I/20 nominal capacity indicates the battery's initial ability to deliver energy for a very precisely specified standard pulse according to EN 50342.

However, because these parameters are initial values and defined for very special or even artificial measurement conditions, they are not sufficient for estimating the true available energy and power during the course of the battery lifetime for a multitude of typical use cases. This is why there is a need for battery monitor systems which allow determining the present state of a battery. Such a monitor system can be implemented by means of dedicated battery sensors (e.g. as part of a so called Battery Monitor, BM) for measuring current, voltage and temperature (IVT) values of the battery. The values can then be fed into a battery model which returns a deterioration signal as a measure for the battery state. The required calculations can be executed by an evaluation device, which can be integrated into or separate from the battery sensors.

Due to their complexity, however, these battery models typically suffer from lack of exactness. Especially lead-acid type batteries are complex to model. Furthermore, the computation means of said Battery Monitors are limited, thus also limiting the possible complexity of the applied model.

Another problem lies in that a model reproduces a theoretical behavior of the battery leading to abstract values. The battery state index returned by such a model, however, should allow for a simple qualitative assessment of the battery state in typical use cases. In other words, providing an index which refers to values only achievable e.g. by a high voltage charging method as required by a certain standard, but unfortunately never experienced in normal usage, dissatisfies the non-expert user.

Some known battery models return an easily comprehensible index like the State of Charge (SoC), the State of Health (SoH), the State of Function (SoF), or a combination thereof. But these battery state indexes, although being intuitively understandable, are not universally and precisely defined. Attempts to define such an intuitive measure may often lead to inconsistent or arbitrarily detailed definitions.

A quite general definition of the State of Health is based on the ratio between the actual capacity $C_{act}$ and the nominal capacity $C_{nom}$ of the battery:

$$SoH = C_{act} / C_{nom}.$$

The greater the difference between the actual capacity and the nominal capacity, the greater is the deterioration of the battery and the lower is the State of Health. The actual capacity, however, is hard to measure. Several different features of the battery can be considered as indicators for the actual capacity, e.g. the voltage change as a result of charging, the dynamic internal resistance, the spectral internal resistance, the charging current at the end of charge, or stress class statistics. In practice, establishing a reliable correlation between such features and the true actual capacity - especially for a wide spectrum of possible depletion modes - proves to be difficult.

The invention is therefore based on the object of providing a system and a method for determining the deterioration of a battery which is simple and leads, on the one hand, to an intuitively comprehensible index and, on the other hand, to reliably measurable and comparable values.

This problem is solved by a system as claimed in claim 1 as well as by a method as claimed in claim 9.

In particular, the problem is solved by: synchronous measuring of a sequence of voltage values depending on respective voltages of the battery and of a sequence of current values depending on respective currents of the battery; subsequently fitting a battery state model to said sequences and deriving a goodness of fit from the fitting; and, finally, generating a deterioration signal based on the goodness of fit. This deterioration signal can then serve as an index for the state of the battery. The index can further be used to trigger a response depending on the battery state, e.g. to disable certain battery dependent services or to indicate a request to exchange the battery, if the battery deterioration exceeds certain levels.

A principle idea of the invention is to use the goodness of fit value for quantitative assessment of the grade of depletion of the battery. The experience with aged and/or depleted batteries has shown that the agreement between the expected and the actually measured correlation of the voltage and current values decreases, when the battery state worsens. As has been found, the goodness of fit quite well reflects this decrease.

The depletion can result from various impacts on the battery, such as wear-out, aging, or stress, which lead to battery deterioration. All these impacts have in common that they influence the dynamic internal resistance $R_{IN}$. Being a measure for the correlation between the output voltages and the output currents of the battery, the dynamic internal resistance can easily be obtained by fitting a simple, in particular linear, model to measured sequences of voltage and current values.

While it would be difficult to provide a reliable transfer function for the State of Health based on the internal resistance due to the fact that also the open circuit voltage, the temperature and internal resistances of parallelly connected loads and actuators would have to be taken in to account, a goodness of fit can be readily derived from the internal resistance by fitting an appropriate model to the voltage and current values. By using a fully deterministic fitting algorithm, a goodness of fit value can reproducibly be determined for a given set of voltage and current values.

In order to be a good measure for the internal resistance the voltage and current values are to be measured synchronously. This means that for each voltage value of the sequence of voltage value there is a corresponding current value of the sequence of current values that has been measured essentially at the same time as the respective voltage value. Though the time intervals between subsequent measurements of voltage and current value pairs may vary, the sequence of measurements is preferentially isochronous.

Furthermore, if a battery is configured as a multiple battery pack, voltage and current sequences are preferably measured for each battery of the battery pack individually.

The goodness of fit can be a measure for the deviation between the fitted model and the original data the model is fitted to. In particular, a higher goodness of fit values can indicate a larger deviation. Then, the ideal goodness of fit value of zero means that the correlation between voltage and current of the battery (which usually corresponds to the internal resistance) is regular (i.e. in particular constant) during the whole duration of the measurement. Thus, a small goodness of fit value indicates that the battery's ability to provide energy is kept constant, which is a characteristic of a healthy battery.

In contrast, a high goodness of fit value would indicate that during the duration of the measurements, especially under the stress of the initial demand for current, the characteristics of the battery change. Thus, the correlation between voltage and current deviates from the expected regular, e.g. linear, behavior which can be observed for a new and healthy battery. This deviation can directly and quantitatively be evaluated by calculating the goodness of fit.

The benefit of the presented approach lies in that the weakness of a battery will be made "visible" by means of a goodness of fit value regardless of the root cause of the deterioration. Every deterioration mechanism, such as mechanical damage, corrosion, irreversible sulfation, water loss, and loss of active mass due to shedding, will cause a worsening of the goodness of fit value which can easily be determined.

Advantageous embodiments of the invention can be found in the dependent claims, the description, and the figures.

In accordance with an embodiment of the invention, the battery sensor of the system is configured to measure the sequence of voltage values and the sequence of current values during a high energy discharge pulse applied to the battery. Such a discharge pulse can in particular comprise a crank discharge pulse and can be part of normal vehicle operation or applied solely for the purpose of measurement. One advantage of measuring voltage and current during an energy discharge pulse of significant intensity relates to the fact that high voltage and current values exhibit a better signal-to-noise ratio than low values. Measuring of the sequences of voltage and current values preferably takes place recurrently, thus allowing for continuous monitoring of the battery state. Conveniently, during normal vehicle operation high energy discharge pulses occur sufficiently often for regular updates of the deterioration signal.

In another embodiment of the invention, the model fitted to said sequences is a linear regression model. The slope of the model can then be interpreted as the internal resistance $R_{IN}$, while the y-axis intercept can correspond to the open circuit voltage $V_0$. A linear regression model can easily be fitted to essentially linearly correlated data, such as the voltage and current values. Several reliable and efficient fitting algorithms for linear regression are known in the art.

In accordance with an embodiment, the evaluation device of the system is adapted to fit the model to said sequences by approximation according to the method of least squares. A least square approximation is quite sensitive to data points deviating from the approximated fit. Therefore, it provides a good fitting precision. Furthermore, the squared deviation between the data points and the fitted model obtained during the approximation can readily be used for determining the goodness of fit, as will be explained later.

According to an embodiment, the evaluation device is adapted to determine a sequence of error values derived from a respective deviation between the fitted model and the sequence of voltage values and/or the sequence of current values, wherein the goodness of fit is based on the sum of the error values, in particular the sum of the absolute error values. An error value can be derived for each data pair consisting of a voltage value and a corresponding current value from the sequences of voltage and current values. Thus, the sequence of error values preferably has the same length as the sequences of voltage and current values, respectively. In particular, this error value can be the difference between an approximated voltage value and the original voltage value or between an approximated current value and the original current value, or a combination thereof.

From these error values, the goodness of fit can then be calculated by, for example, simply summing up the error values. A more rigorous goodness of fit can alternatively be obtained by first calculating the absolute values of the error values and then summing up these absolute values. Additionally, the respective sum of (direct or absolute) error values can be multiplied by a factor, e.g. a normalization factor or the inverse variance of the data set, or be otherwise further processed for the determination of the goodness of fit. Since the sum of error values increases with increasing deviation between the measured data and the fitted model, a low goodness of fit value indicates a good fit and, thus, low deterioration of the battery. However, there are other possible definitions of the goodness of fit, where a higher value corresponds to a better fit and a lower battery deterioration.

In accordance with another embodiment, the evaluation device is adapted to determine a sequence of error values derived from a respective deviation between the fitted model and the sequence of voltage values and/or the sequence of current values, wherein the goodness of fit is based on the sum of the squared error values. Again, the sum can additionally be multiplied by a factor or be otherwise further processed. By squaring the error values, larger deviations between the original data and the fit are given more weight than smaller deviations. This leads to an even more rigorous definition of the goodness of fit which is more sensitive to a departure of the fitted model from the actual correlation between the voltage and the current of the battery. In this way, the deterioration signal is quasi amplified such that the battery state can be determined at a finer resolution.

In order to indicate the state of the battery to a user, in a further embodiment of the invention, the system further comprises a display device configured to obtain the deterioration signal from the evaluation device and to indicate the deterioration of the battery in response to the deterioration signal. The display can be configured to display information about the deterioration of the battery continuously or only under specific circumstances such as after exceeding a threshold. Thus, a user can readily capture information on the battery state.

In a preferred embodiment, the model relates the voltage values $V_i$ to the current values $I_i$ by the formula

$$V = V_0 + I \cdot R_{\mathrm{IN}},$$

wherein V is the voltage, I is the current, $V_0$ is the open circuit voltage, and $R_{\mathrm{IN}}$ is the dynamic internal resistance of the battery. By applying this formula, every current value $I_i$ is assigned a fitted voltage value

$$V_{\mathrm{fitted},i} = V_0 + I_i \cdot R_{\mathrm{IN}}.$$

The goodness of fit *GoF* can be computed as the sum of residual errors of the fitting, which e.g. is a linear regression. In particular, the goodness of fit is one of

$$GoF = \Sigma_i \, e_i,$$

$$GoF = \Sigma_i \, |e_i|,$$

and

$$GoF = \Sigma_i \, e_i^2;$$

with $e_i = V_{\mathrm{fitted},i} - V_i$ being the deviation between the fitted model and the voltage values.

Alternatively, the sequences of voltage and current values can be fitted by

$$I_{\mathrm{fitted},i} = I_0 + V_i \, / R_{\mathrm{IN}}.$$

The error values can then be defined as $e_i = I_{\mathrm{fitted},i} - I_i$.

The characteristics and advantages described with respect to the claimed system and its embodiments are mutatis mutandis also applicable to the claimed method of determining the deterioration of a battery.

In the following, different embodiments of the invention will be described purely by way of example with reference to the submitted drawing. The Figures of the drawing show:

Fig. 1     an embodiment of the battery deterioration determining system in a schematic representation;

Fig. 2A and 2B     diagrams showing the measured sequences of voltage and current values and the fitted correlation between voltage and current in case of a healthy battery;

Fig. 3A and 3B    diagrams showing the measured sequences of voltage and current values and the fitted correlation between voltage and current in case of a deteriorated battery;

Fig. 4    a diagram showing the development of the goodness of fit value over time for a progressively deteriorating battery.

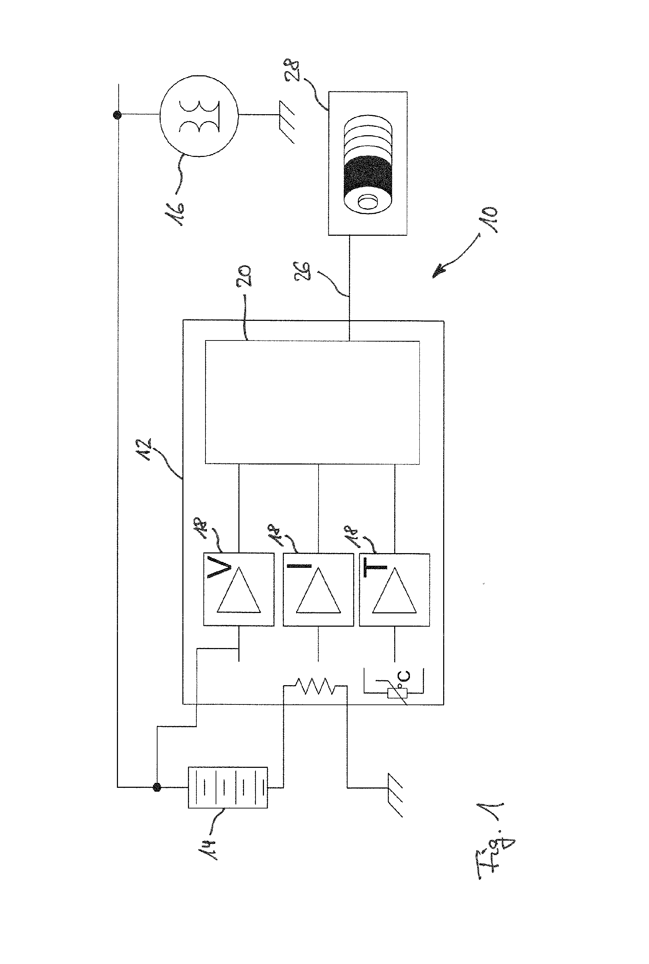

Fig. 1 shows an embodiment of a battery deterioration determining system 10. The system 10 comprises a battery sensor 12, which is connectable to a battery 14. The battery 14 shown in Fig. 1 is a lead-acid type SLI battery of a vehicle (not shown). Among other things, the battery 14 serves as energy supply for a starter 16 of the vehicle's engine (not shown).

The battery sensor 12 comprises individual sensing devices 18. One of the sensing devices 18 is a voltage meter V connected to the battery 14, another sensing device 18 is a current meter I inductively coupled to the battery 14. In addition, the battery sensor 12 has a temperature meter T, which determines the actual temperature from changes in thermal resistance.

The outputs of these sensing devices 18 are fed to an evaluation device 20, which, in the case of the given embodiment, is integrated into the battery sensor 12.

During a high energy crank discharge pulse, when the starter 16 heavily draws current from the battery 14, the battery sensor 12 can synchronously measure a sequence of voltage values 22 by means of the voltage meter V and a sequence of current values 24 by means of the current meter I. The evaluation device 20 receives these voltage and current value sequences 22, 24 from the sensing devices 18 and fits a model for the correlation between these values to the data.

The fitting is performed by the evaluation device 20 as a linear regression using the formula $V = V_0 + I \cdot R_{IN}$, wherein the approximation can also follow the method of least squares. As a result of the fitting procedure, the open circuit voltage $V_0$ and the internal resistance $R_{IN}$ can be obtained and be used to calculate voltage values $V_{fitted,i}$ for each current value $I_i$ in accordance with the determined fitting coefficients $V_0$ and $R_{IN}$.

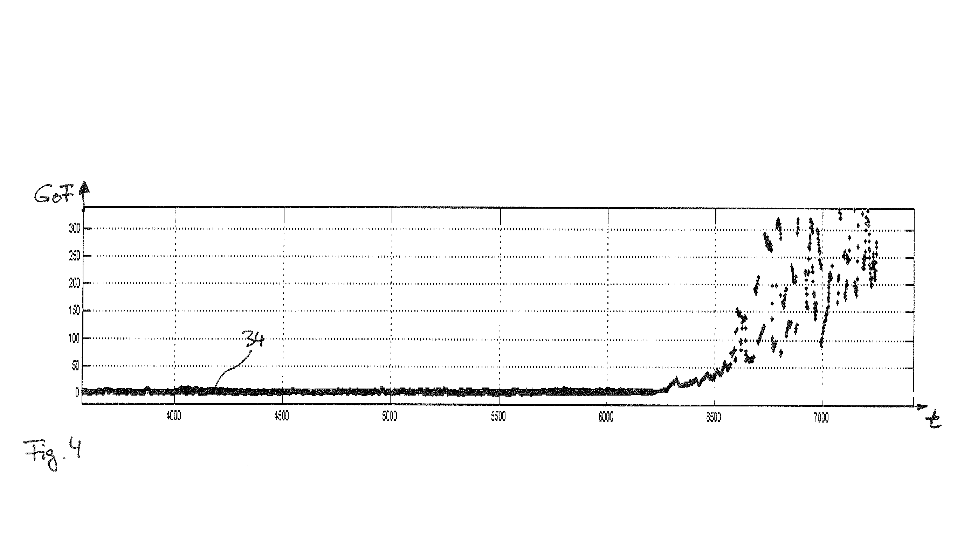

The evaluation device 20 can then derive a goodness of fit value $GoF$ 34 (cf. Fig. 4) from the deviation between the calculated values $V_{fitted,i}$ obtained from the fit and the original values $V_i$ measured by the battery sensor 12. Based on this goodness of fit value 34 the evaluation device 20 generates a deterioration signal 26, which is output to a display device 28 of the system 10. In particular, the display device 28 can be configured to optically indicate the state of the battery 14 in response to the obtained deterioration signal 26. Alternatively or additionally, the display device 28 can indicate a warning, if the deterioration signal 26 exceeds a predetermined or chosen threshold. Moreover, the display device 28 can also serve to indicate further information about the battery 14, such as a state of charge.

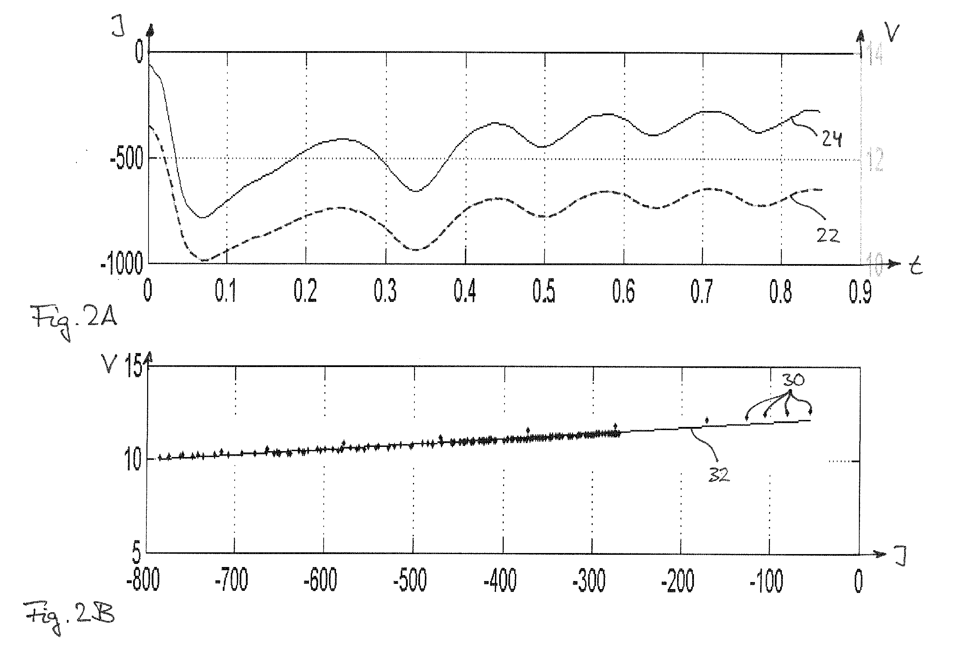

Fig. 2A shows a measured sequence of voltage values 22 superimposed with a measured sequence of current values 24, both sequences 22, 24 being recorded synchronously during the same crank discharge pulse applied to the battery 14 by the starter 16. The correlation between these sequences 22, 24 is evident from Fig. 2B, where the voltage values 22 are plotted against the current values 24 in a scatter plot, with each dot of the plot representing a pair of voltage-current values 30. The straight line 32 describes the result of fitting the voltage-current correlation model to the measured values by linear regression. This fitted model 32 is then taken as reference to determine a sequence of error values, with each error value being calculated as the distance of an original voltage-current value pair 30 from the fitted model 32, wherein various known metrics can be used for the distance determination.

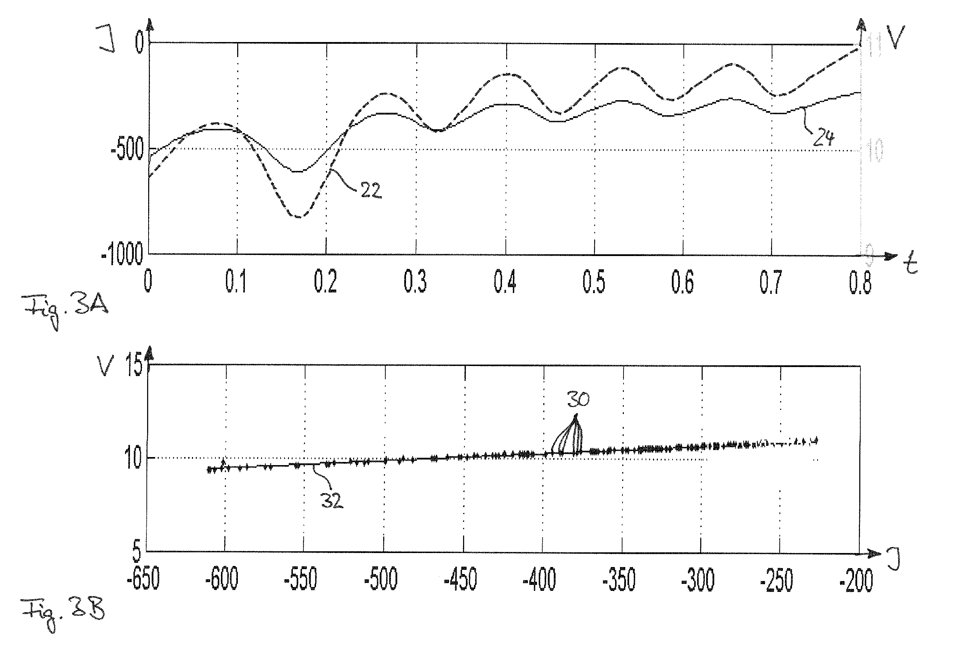

While Fig. 2A and 2B show diagrams for data obtained from a healthy battery 14, the diagrams of Fig. 3A and 3B show the same kind of data in an equivalent representation as in Fig. 2A and 2B, respectively, for data which has been obtained from a deteriorated battery 14. From Fig. 3A it is evident that the correlation between the voltage values 22 and the current values 24 is not constant during the measurement. Thus, although the corresponding voltage-current value pairs 30 in Fig. 3B can nevertheless be fitted by linear approximation, the fitted model 32 shows more deviation from the original data than was the case for the healthy battery 14. Therefore, though it is hardly perceptible in Fig. 3B, also the error values are collectively greater for the deteriorated battery 14.

To determine a quantitative index for the deterioration of the battery 14, a goodness of fit 34 is derived from the error values by calculating the sum of the squares of the error values.

In Fig. 4 a series of goodness of fit values 34 as obtained from a multitude of measurements is plotted over time. All the measurements have been executed on the same battery 14, which was new and healthy at the time of the first measurement. Therefore, the goodness of fit values 34 are small and close to the ideal value of zero, at first. However, as is apparent from Fig. 4, starting at a lifetime of about 6200 hours, the goodness of fit 34 increases steadily. This is due to a progressive deterioration of the battery 14, which is directly reflected by the time course of the goodness of fit 34.

Hence, the goodness of fit 34 can be used as a simple yet reliable direct measure for the deterioration of a battery 14 and, thus, forms a good basis for the deterioration signal 26 generated and output by the battery deterioration system 10.

List of reference numerals

| | |
|---|---|
| 10 | battery deterioration determining system |
| 12 | battery sensor |
| 14 | battery |
| 16 | starter |
| 18 | sensing devices |
| 20 | evaluation device |
| 22 | sequence of voltage values |
| 24 | sequence of current values |
| 26 | deterioration signal |
| 28 | display device |
| 30 | voltage-current value pair |
| 32 | fitted model |
| 34 | goodness of fit |

**Claims**

1. A system (10) for determining the deterioration of a battery (14), particularly in an automotive system, comprising:

   a battery sensor (12) configured to measure voltage values depending on respective voltages of the battery (14) and to measure current values depending on respective currents of the battery (14); and
   an evaluation device (20) connected to the battery sensor (12) for receiving the voltage and current values from the battery sensor (12), the evaluation device (20) being adapted to generate a deterioration signal (26) in response to the received voltage and current values;
   **characterized in that**
   the battery sensor (12) is configured to synchronously measure a sequence of voltage values (22) and a sequence of current values (24), wherein the evaluation device (20) is adapted to fit a model to said sequences (22, 24), to derive a goodness of fit (34) from the fitting, and to generate the deterioration signal (26) based on the goodness of fit (34).

2. A system as claimed in claim 1,
   **characterized in that**
   the battery sensor (12) is configured to measure the sequence of voltage values (22) and the sequence of current values (24) during an energy discharge pulse, in particular a crank discharge pulse, applied to the battery (14).

3. A system as claimed in claim 1 or 2,
   **characterized in that**
   the model is a linear regression model.

4. A system as claimed in any of claims 1 to 3,
   **characterized in that**
   the evaluation device (20) is adapted to fit the model to said sequences (22, 24) by approximation according to the method of least squares.

5. A system as claimed in any of claims 1 to 4,
   **characterized in that**
   the evaluation device (20) is adapted to determine a sequence of error values derived from a respective deviation between the fitted model (32) and the sequence of voltage values (22) and/or the sequence of current values (24), wherein the goodness of fit (34) is based on the sum of the error values, in particular the sum of the absolute error values.

6. A system as claimed in any of claims 1 to 4,
   **characterized in that**
   the evaluation device (20) is adapted to determine a sequence of error values derived from a respective deviation between the fitted model (32) and the sequence of voltage values (22) and/or the sequence of current values (24), wherein the goodness of fit (34) is based on the sum of the squared error values.

7. A system as claimed in any of claims 1 to 6,
   **characterized in that**
   it further comprises a display device (28) configured to obtain the deterioration signal (26) from the evaluation device (20) and to indicate the deterioration of the battery (14) in response to the deterioration signal (26).

8. A system as claimed in any of claims 1 to 7,
   **characterized in that**
   the model relates the voltage values $V_i$ to the current values $I_i$ by the formula $V = V_0 + I \cdot R_{IN}$, wherein V is the voltage, I is the current, $V_0$ is the open circuit voltage, and $R_{IN}$ is the dynamic internal resistance of the battery (14), whereby every current value $I_i$ is assigned a fitted voltage value $V_{fitted},i = V_0 + I_i R_{IN}$, wherein the goodness of fit $GoF$ (34) is in particular one of $GoF = \sum_i e_i$, $GoF = \sum_i |e_i|$, and $GoF = \sum_i e_i^2$, with $e_i = V_{fitted,i} - V_i$ being the deviation between the fitted model (32) and the voltage values.

9. A method of determining the deterioration of a battery (14), particularly in an automotive system, comprising:

   - measuring voltage values depending on respective voltages of the battery (14); and
   - measuring current values depending on respective currents of the battery (14);
   - generating a deterioration signal (26) in response to the voltage and current values;
   **characterized in that**
   said measuring of voltage and current values comprises synchronous measuring of a sequence of voltage values (22) and a sequence of current values (24), wherein said generating the deterioration signal (26) comprises:
- fitting a model to said sequences (22, 24);
- deriving a goodness of fit (34) from the fitting; and
- generating the deterioration signal (26) based on the goodness of fit (34).

10. A method as claimed in claim 9,
**characterized in that**
the sequence of voltage values (22) and the sequence of current values (24) are measured during an energy discharge pulse, in particular a crank discharge pulse, applied to the battery (14).

11. A method as claimed in claim 9 or 10,
**characterized**in that
the model is a linear regression model.

12. A method as claimed in any of claims 9 to 11,
**characterized in that**
said fitting of the model to said sequences (22, 24) comprises approximating the model to said sequences (22, 24) according to the method of least squares.

13. A method as claimed in any of claims 9 to 12,
**characterized in that**
said deriving of a goodness of fit (34) comprises determining a sequence of errors derived from a respective deviation between the fitted model (32) and the sequence of voltage values (22) and/or the sequence of current values (24), and calculating the sum of the errors, in particular the sum of the absolute errors.

14. A method as claimed in any of claims 9 to 12,
**characterized in that**
said deriving of a goodness of fit (34) comprises determining a sequence of errors derived from a respective deviation between the fitted model (32) and the sequence of voltage values (22) and/or the sequence of current values (24), and calculating the sum of the squared errors.

15. A method as claimed in any of claims 9 to 14,
**characterized in that**
the model relates the voltage values $V_i$ to the current values $I_i$ by the formula $V = V_0 + I \cdot R_{IN}$, wherein V is the voltage, I is the current, $V_0$ is the open circuit voltage, and $R_{IN}$ is the dynamic internal resistance of the battery (14), whereby every current value $I_i$ is assigned a fitted voltage value $V_{fitted,i} = V_0 + I_i \cdot R_{IN}$, wherein the goodness of fit $GoF$(34) is in particular one of $GoF = \sum_i e_i$, $GoF = \sum_i |e_i|$, and $GoF = \sum_i e_i^2$, with $e_i = V_{fitted,i} - V_i$ being the deviation between the fitted model (32) and the voltage values.

Fig. 1

Fig. 2A

Fig. 2B

EP 2 821 803 A1

Fig. 3A

Fig. 3B

Fig. 4

Europäisches
Patentamt
European
Patent Office
Office européen
des brevets

# EUROPEAN SEARCH REPORT

Application Number

EP 13 17 4720

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2004/251875 A1 (KINOSHITA TAKUYA [JP] ET AL) 16 December 2004 (2004-12-16) <br> * paragraph [0037] - paragraph [0045] * <br> * figures 5,6,8,10,13 * <br> * paragraph [0047] * <br> * claim 3 * | 1-15 | INV. <br> G01R31/36 |
| X | EP 2 551 688 A1 (YOKOGAWA ELECTRIC CORP [JP]) 30 January 2013 (2013-01-30) <br> * paragraph [0057] - paragraph [0062] * | 1,9 | |
| X | JP 2010 036718 A (MITSUBISHI MOTORS CORP) 18 February 2010 (2010-02-18) <br> * paragraphs [0016], [0023], [0026] - paragraph [0027] * <br> * figures 3,5 * <br> * equation (1) * | 1,9 | |
| X | JP H04 215083 A (YUASA BATTERY CO LTD; SHIKOKU SOGO KENKYUSHO KK; SHIKOKU ELEC POWER) 5 August 1992 (1992-08-05) <br> * abstract * | 1,9 | TECHNICAL FIELDS SEARCHED (IPC) <br><br> G01R |

The present search report has been drawn up for all claims

| Place of search | Date of completion of the search | Examiner |
|---|---|---|
| Munich | 6 December 2013 | Hof, Klaus-Dieter |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**                    EP 13 17 4720

This annex lists the patent family members relating to the patent documents cited in the above-mentioned European search report.
The members are as contained in the European Patent Office EDP file on
The European Patent Office is in no way liable for these particulars which are merely given for the purpose of information.

06-12-2013

| Patent document cited in search report | | Publication date | Patent family member(s) | | Publication date |
|---|---|---|---|---|---|
| US 2004251875 | A1 | 16-12-2004 | DE | 102004009328 A1 | 05-01-2005 |
| | | | DE | 102004063956 B4 | 10-04-2008 |
| | | | JP | 4377164 B2 | 02-12-2009 |
| | | | JP | 2005003414 A | 06-01-2005 |
| | | | US | 2004251875 A1 | 16-12-2004 |
| EP 2551688 | A1 | 30-01-2013 | CN | 102901928 A | 30-01-2013 |
| | | | EP | 2551688 A1 | 30-01-2013 |
| | | | JP | 5278508 B2 | 04-09-2013 |
| | | | JP | 2013026114 A | 04-02-2013 |
| | | | KR | 20130012569 A | 04-02-2013 |
| | | | US | 2013030736 A1 | 31-01-2013 |
| JP 2010036718 | A | 18-02-2010 | NONE | | |
| JP H04215083 | A | 05-08-1992 | JP | 2974157 B2 | 08-11-1999 |
| | | | JP | H04215083 A | 05-08-1992 |

EPO FORM P0459

For more details about this annex : see Official Journal of the European Patent Office, No. 12/82